(19) Europäisches Patentamt
European Patent Office
Office européen des brevets

(11) **EP 2 455 435 A1**

(12) **EUROPEAN PATENT APPLICATION**
published in accordance with Art. 153(4) EPC

(43) Date of publication:
**23.05.2012 Bulletin 2012/21**

(51) Int Cl.:
*C09J 9/02* (2006.01)   *C09J 5/02* (2006.01)

(21) Application number: **10799959.1**

(22) Date of filing: **27.01.2010**

(86) International application number:
**PCT/KR2010/000477**

(87) International publication number:
**WO 2011/007947 (20.01.2011 Gazette 2011/03)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **13.07.2009 KR 20090063434**

(71) Applicant: **Korea Advanced Institute of Science and Technology**
**Daejeon-si 305-701 (KR)**

(72) Inventors:
• **PAIK, Kyung-Wook**
  **Daejeon 305-701 (KR)**
• **LEE, Kiwon**
  **Daejeon 305-701 (KR)**
• **KIM, Seung Ho**
  **Daejeon 305-701 (KR)**

(74) Representative: **Grünecker, Kinkeldey, Stockmair & Schwanhäusser**
**Leopoldstrasse 4**
**80802 München (DE)**

(54) **ANISOTROPIC CONDUCTIVE ADHESIVE FOR ULTRASONIC WAVE ADHESION, AND ELECTRONIC PARTS CONNECTION METHOD USING SAME**

(57) The present invention is to provide an anisotropic conductive adhesive (ACA) for ultrasonic wave adhesion, which electrically connects a first electrode, which is an electrode of a connection portion of a first electronic component, with a second electrode, which is an electrode of a connection portion of a second electronic component. The anisotropic conductive adhesive includes an insulating polymer resin, conductive adhesive particles which are melted by heat generated from the ultrasonic waves applied to the anisotropic conductive adhesive, and spacer particles, which have a melting point higher than that of the adhesive particles, and wherein the adhesive particles are melted and made to come in surface contact with at least one electrode selected from the first electrode and the second electrodes, and the first electrode and the second electrode are electrically connected with a constant gap maintained between the first electrode and the second electrode by the spacer particles.

FIG. 2

## Description

## BACKGROUND OF THE INVENTION

The present invention relates to an anisotropic conductive adhesive (ACA) for electrically connecting a first electrode, which is an electrode of a connection portion of a first electronic component, and a second electrode, which is an electrode of a connection portion of a second electronic component, and a method of interconnecting electronic components using the same.

The anisotropic conductive adhesives may be adhesive materials that simultaneously perform electrical interconnection of electrodes via conductive particles based on an insulating polymer resin and conductive particles dispersed in the polymer resin, and mechanical connection via thermal curing of the polymer resin.

In general, fine particles, such as gold, cooper, nickel, carbon, a metal-coated polymer, an intrinsically conductive polymer, etc. are used as conductive particles, and an epoxy resin, a polyimide resin, a silicon resin, an acrylic resin, a polyester resin or a polysulfone resin are used as a polymer resin. According to the field of application, the types of conductive particles may vary, and they may include non-conductive particles for the purpose of reducing the coefficient of thermal expansion.

In the method of interconnecting electronic component using an anisotropic conductive adhesive, there are advantages in that it is clean, simple and environmentally friendly because an existing soldering process is replaced with a lead-free process, it is more thermally stable because there is no need to apply the instantaneous temperature to the product (low temperature process), the cost of the process can be reduced by using a cheap substrate, such as a glass substrate or polyester flex, and an ultra-fine electrode pitch can be implemented via electrical connection using fine conductive particles.

The anisotropic conductive adhesives having these advantages are widely used in applications such as smart cards, liquid crystal displays (LCD), plasm display panels (PDP), display packaging of organic light remitting diodes, computers, portable telephones, communication systems, etc.

The anisotropic conductive adhesives are commonly used in display module mounting technologies for outer lead bonding (OLB) when connecting a flexible substrate to a glass substrate and for bonding the flexible substrate with a printed circuit board (PCB). The market for anisotropic conductive adhesives is growing rapidly.

In addition, in bonding processes of a COG (Chip On Glass), in which a driving circuit IC chip is directly connected to the glass substrate, and a COF (Chip On Film), in which a flip chip is directly connected to the flexible substrate, since a connection having an ultra-fine pitch is required due to the increasing densification and complexity of the driving circuit IC, the importance of anisotropic conductive adhesives is also increasing rapidly.

Tin the mounting technology of the electronic components using the anisotropic conductive adhesive, connection is achieve via electrical conduction of conductive particles between electrode pads using a thermocompression process and thermo-setting of a polymer resin.

When using the anisotropic conductive adhesive, several problems, such as uneven thermo-setting of the polymer resin, distortion due to residual stress generated in the process of heating and cooling, thermal deformation, plate flatness and the like, must be resolved. Further, there is a problem of high contact resistance of the electrical connection of the electronic components due to point contact between the electrodes of the electronic components and the conductive particles of the anisotropic conductive adhesive.

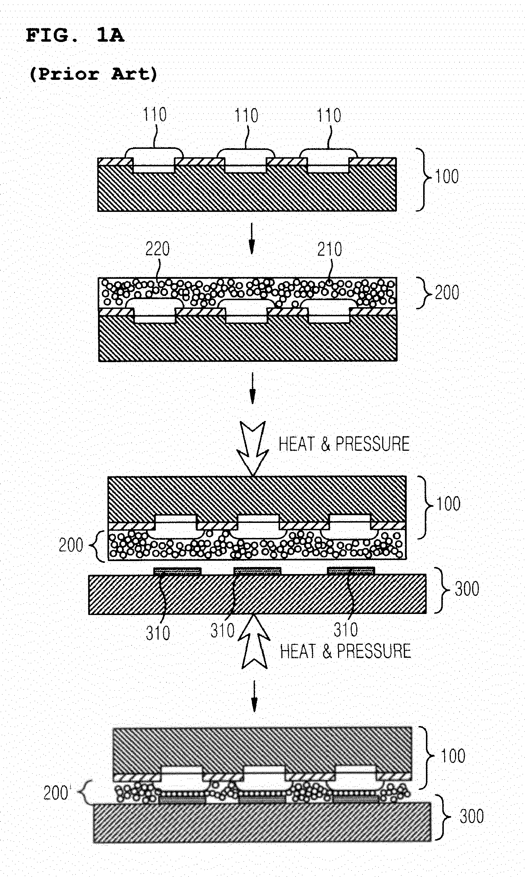

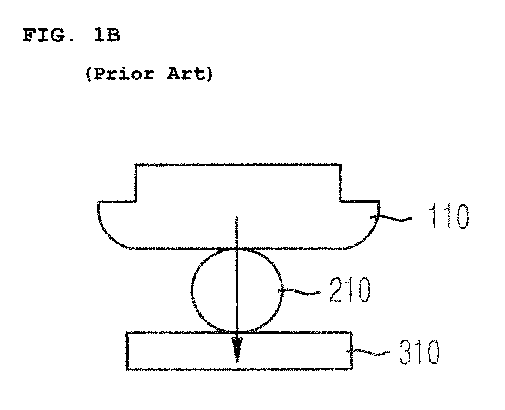

In detail, FIG. 1A illustrates the conventional method for interconnecting two electronic components 100 and 300, which are connection targets. As shown in FIG. 1A, the electronic component 100, which is one connection target, includes electrodes 110 formed in the upper surface portion thereof. The upper surface portion of the electronic component 100 is coated with anisotropic conductive paste 200, or has an anisotropic conductive film 200 attached thereto, which is an anisotropic conductive adhesive containing an insulating thermosetting polymer resin 220 and conductive metal particles 210, and is then arranged with electrodes 310 of the electronic component 300, which is the other connection target. Thereafter, the polymer resin is cured by applying heat and pressure, and the two electrodes 110 and 310 become electrically conductive.

However, in the conventional technique, the conductive particles 210 are simply in physical contact with the electrodes 110 and 310, as shown in TIG. 1B. accordingly, due to the physical point contact, contact resistance between the two electrodes may be high, and the flow of current may be limited.

## SUMMERY OF THE INVENTION

An embodiment of the present invention is directed to an anisotropic conductive adhesive used for an electrical connection, wherein contact resistance between two electrodes, which are connection targets, can be considerably reduced, and a large amount of current can flow, thus realizing high reliability.

Another embodiment of the present invention is directed to a method of interconnecting electronic components using ultrasonic waves, wherein an anisotropic conductive adhesive can be uniformly cured to improve reliability, electronic components, which are connection targets, may be deformed by heat, and contact resistance between the electrodes of electronic components may be very low.

In accordance with an embodiment of the present invention, in an anisotropic conductive adhesive (art) for ultrasonic wave adhesion, which electrically connects a first electrode, which is an electrode of a connection portion of a first electronic component, with a second electrode, which is an electrode of a connection portion of a second electronic component, the anisotropic conductive adhesive includes an insulating polymer resin, conductive adhesive particles, which melt due to heat generated from the ultrasonic waves applied to the anisotropic conductive adhesive, and spacer particles, which have a melting point higher than that of the adhesive particles, and the adhesive particles are melted and made to come in surface contact with at least one electrode selected from the first electrode and the second electrode, and the first electrode and the second electrode are electrically connected with a constant gap maintained between the first electrode and the second electrode by the spacer particles.

In the anisotropic conductive adhesive of the present invention, plastic deformation of the polymer resin may be caused by the applied ultrasonic waves, and the adhesive particles may be melted by the self-heating of polymer resin according to the plastic deformation.

In addition, in the anisotropic conductive adhesive of the present invention, when the ultrasonic waves are applied, the spacer particles may maintain a solid state, and when the first electronic component and the second electronic component are connected, the gap between the first electrode and the second electrode may be maintained against the applied pressure. Further, in the spacer particles, the gap between the first electrode and the second electrode may be maintained against the applied pressure when the first electronic component and the second electronic component are connected, such that the melted adhesive particles have uniform adhesion appearances.

The adhesive particles and the spacer particles satisfy the following Equation 1.

【Equation 1】

$$T_m{}^c \leq 0.9\ T_m{}^s$$

($T_m{}^c$ is the melting point (°C)) of the adhesive particles and $T_m{}^s$ is the melting point (°C) of the spacer particles.)

In addition, the adhesive particles and the spacer particles, which satisfy the relationship of Equation 1, can satisfy the following Equations 2 and 3.

【Equation 2】

$$120\,°\!C\ \leq\ T_m{}^c\ \leq\ 300\,°\!C$$

($T_m{}^c$ is the melting point (°C) of the adhesive

particles.)
【Equation 3】

$$200\,°\!C\ \leq\ T_m{}^s\ \leq\ 5000\,°\!C$$

($T_m{}^s$ is the melting point (°C) of the spacer particles.)

In addition, in the anisotropic conductive adhesive of the present invention, the average particle diameter of the adhesive particles may be larger than that of the spacer particles, and the average particle diameters of the adhesive particles and the spacer particles may be 3μm to 100 μm, independently of each other.

In the interests of mass production, manufacturing costs and selective conduction, the spacer particles may be non-conductive particles.

In the interests of contact resistance, when electronic components are interconnected, the spacer particles may be conductive particles.

In the interests of mass production, manufacturing costs, selective conduction, and contact resistance, the spacer particles may be mixed particles, comprising a mixture of conductive particles and non-conductive particles.

In addition, in the anisotropic conductive adhesive of the present invention, the insulating polymer resin may be a thermosetting polymer resin or a thermoplastic polymer resin. When the insulating polymer resin is a thermosetting polymer resin, the thermosetting polymer resin may be cured, and the conductive adhesive particles may be melted by the applied ultrasonic waves. Further, when the insulating polymer resin is a thermosetting polymer resin, the thermoplastic polymer resin may be melted, and the conductive adhesive particles may be melted.

Meanwhile, in a single process, in which an ultrasonic wave is applied to the anisotropic conductive adhesive, the conductive adhesives particles within the anisotropic conductive adhesive according to the present invention may be welded while the thermosetting polymer resin is cured, or the thermoplastic polymer resin is melted.

In addition, in the anisotropic conductive adhesive of the present invention, the anisotropic conductive adhesive may contain 5 to 30% by weight of the adhesive particles, and 1 to 50% by weight of the spacer particles.

In addition, in the anisotropic conductive adhesive of the present invention, the adhesive particles may be a Pb-based alloy, an Sn-based alloy, an Sn-Bi based alloy, an Sn-Zn based alloy, an Sn-Ag based alloy, an Sn-Ag-Au based alloy, or a mixture of the alloys, as a solder alloy.

Preferably, the adhesive particles may be lead-free solder, wherein the lead-free solder meets the guidelines of the European Union's RoHS-6 (Restriction of Hazardous Substances).

More preferably, the adhesive particles may be a Pb-based alloy, an Sn-based alloy, an Sn-Bi based alloy, an Sn-Zn based alloy, an Sn-Ag based alloy, an Sn-Ag-Au based alloy or a mixture of the alloys, as a solder alloy.

In addiction, in the anisotropic conductive adhesive of the present invention, the spacer particles may be at least one kind of non-conductive particle selected from polymer particles containing epoxy, polyimide, silicon, acrylic, polyester, polysulfone, and polystyrene, and ceramic particles containing aluminum oxide, silicon oxide, silicon nitride, titanium oxide and diamond, or at least one of conductive particles selected from a polymer coated with silver, gold, copper, nickel, carbon, and an intrinsically conductive polymer.

The anisotropic conductive adhesive may be an anisotropic conductive paste (ACP) or an anisotropic conductive film, preferably the anisotropic conductive film.

The insulating polymer resin may be a thermosetting polymer resin or a thermoplastic polymer resin, and the thermosetting polymer resin may be cured, or the thermoplastic polymer resin and the adhesive particles may be melted by the application of ultrasonic waves. Further, the melted adhesive particles may be made to come in surface contact with at least one electrode selected from the first electrode and the second electrode by the applied pressure and ultrasonic waves. Accordingly, the anisotropic conductive adhesive of the present invention has high reliability.

The adhesives particles may be alloyed with electrode materials of the first electrode or the second electrode by the melting of the adhesive particles, and in detail, the adhesive particles may be alloyed at the interface between the one or more electrodes selected from the first electrode or the second electrode.

In addition, the anisotropic conductive adhesive of the present invention may not contain a reducing agent for the melting of the conductive particles.

In accordance with another embodiment of the present invention, a method of interconnecting electronic components using an anisotropic conductive adhesive for ultrasonic wave adhesion includes (a) forming the anisotropic conductive adhesive of the above-mentioned embodiment on the upper portion of an electrode of a connection portion of a first electronic component, on which electrodes of the connection portion are formed for electrical interconnection of homogeneous or heterogeneous electronic components, and (b) interconnecting the electrodes of the connection portion of the first electronic component and the electrodes of the connection portion of the second electronic component, including forming a laminate including the first electronic component, the anisotropic conductive adhesive and the second electronic component by arranging and stacking the electrode of the connection portion of the second electronic component on the upper side of the electrode of the connection portion of the first electronic component, wherein the anisotropic conductive adhesive is between the electrodes, causing plastic deformation of an insulating thermosetting or thermoplastic polymer resin contained in the anisotropic conductive adhesive by applying ultrasonic vibration and pressure to the laminate, curing or melting the polymer resin contained in the anisotropic conductive adhesive by self-heating of the polymer resin according to the plastic deformation, and melting adhesive particles contained in the anisotropic conductive adhesive.

In addition, in the method of interconnecting electronic components according to the present invention, in the step (b), within the anisotropic conductive adhesive for ultrasonic wave adhesion, the thermosetting polymer resin may be cured or the thermoplastic polymer resin may be melted, and the adhesive particles may be melted by the applied ultrasonic waves.

In addition, in the method of interconnecting electronic components according to the present invention, the temperature of the anisotropic conductive adhesive by self-heating of the thermosetting polymer resin may be controlled by pressure, frequency, amplitude, power and driving time of ultrasonic waves, or a combination of thereof.

In this case, the temperature of the anisotropic conductive adhesive may be within the range of 120 to 300 °C, due to the application of ultrasonic waves in the step (b).

## BRIEF DESCRIPTION OF THE DRAWINGS

FIG. 1A and 1B are flow charts illustrating a method of interconnecting two electronic components using an anisotropic conductive adhesive in accordance with the conventional art;

FIG. 2 is a diagram illustrating an anisotropic conductive adhesive for an ultrasonic wave adhesion in accordance with the present invention; and

FIG. 3 is a flow chart illustrating a method of interconnecting electronic components using an anisotropic conductive adhesive for ultrasonic wave adhesion in accordance with the present invention.

## DESCRIPTION OF SPECIFIC EMBODIMENTS

Hereinafter, exemplary embodiments of an anisotropic conductive adhesive and a method of interconnecting electronic components according to the present invention will be described in detail with reference to the accompanying drawings. The present invention may, however, be embodied in different forms, and should not be constructed as being limited to the embodiments set forth herein. Rather, these embodiments are provide so that this disclosure will be thorough and complete, and will fully convey the scope of the present invention to those skilled in the art.

Throughout the disclosure, like reference numerals refer to like parts throughout the various figures and embodiments of the present invention.

In this case, in the technical and scientific terms described herein, if a different definition is not described, it means that a person having ordinary skill in the art to which this invention pertains can typically understand the invention. In addition, in the description and the accompanying drawings, features and configurations that are already know, whose explanation would cause the gist of the present invention to be unnecessarily blurred, will be omitted.

According to the present invention, the anisotropic conductive adhesive includes an insulating polymer resin 430, adhesives particles 410 and spacer particles 420, which have a melting point higher than that of the adhesive particles. Further, in the anisotropic conductive adhesive for ultrasonic wave adhesion, the polymer, resin 430 may be cured or melted by applying ultrasonic waves to the anisotropic conductive adhesive.

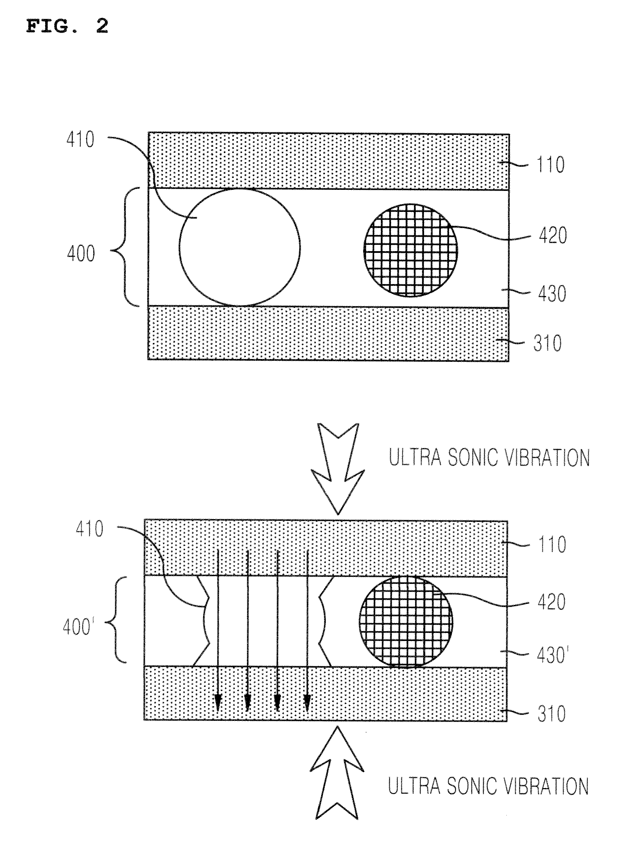

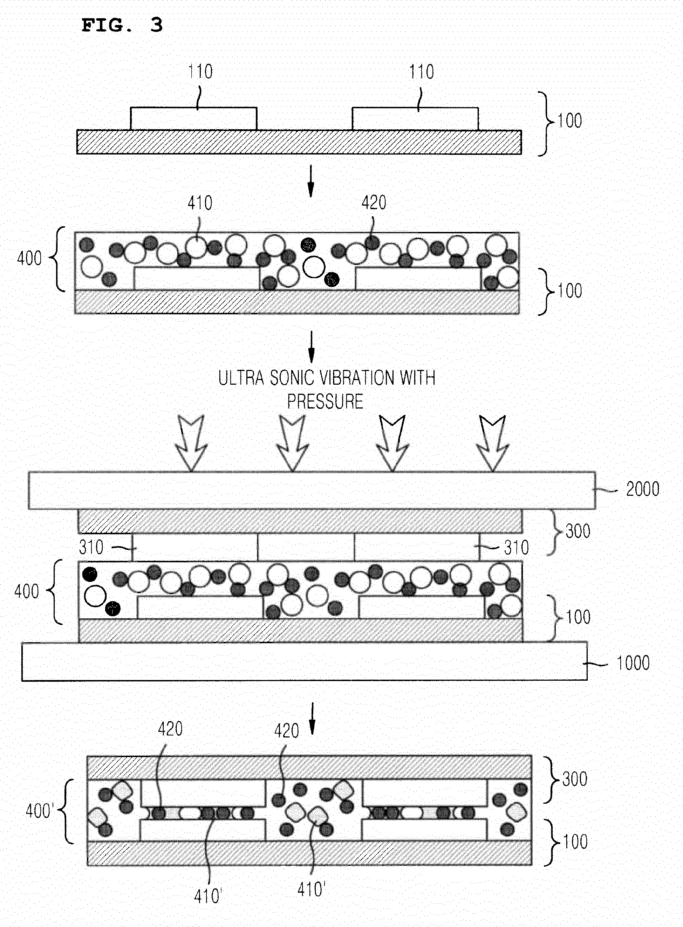

The insulating polymer resin may be a thermosetting polymer resin or a thermoplastic polymer resin, and is preferably a thermosetting polymer resin. Hereinafter, the present invention will be described on the basis of the thermosetting polymer resin with reference to FIGS. 2 and 3. In the discussion below, in the case in which the polymer resin is the thermoplastic polymer resin rather than the thermosetting polymer resin, it will be apparent that the main ideas of the present invention may be maintained, except that the melting of the thermoplastic polymer resin, rather than the curing thereof, is achieve by applying ultrasonic waves.

The application of ultrasonic waves means that ultrasonic vibration is applied to the anisotropic conductive adhesive 400, and the ultrasonic vibration includes the vibration accompanied by a predetermined pressure.

The ultrasonic waves applied to the anisotropic conductive adhesive 400 induce plastic deformation of the polymer resin 430 contained in the anisotropic conductive adhesive 400, and the polymer resin 430 is self-heated by the plastic deformation.

By the self-heating of the polymer resin 430 based on the ultrasonic waves, the temperature of the anisotropic conductive adhesive 400 is raised above the curing temperature of the polymer resin 430.

The anisotropic conductive adhesive 400 according to the present invention may be the anisotropic conductive adhesives 400 for ultrasonic wave adhesion, on which the curing of the adhesive 400 is performed by the above-mentioned ultrasonic vibration. Further, the anisotropic conductive adhesive 400 includes spacer particles, which have a melting point higher than that of the adhesive particles 410.

As shown in FIG. 2, the adhesive particles 410 are conductive particles that melt in the heat that is generated when the ultrasonic waves are applied, and the spacer particles 420 are conductive or non-conductive particles that remain in a solid state even when ultrasonic waves are applied.

When electronic components are interconnected by using the anisotropic conductive adhesive 400 according to the present invention, the adhesive particles 410 between two connection electrodes 110 and 310 of the electronic components, which are connection targets, are melted by the heat that is generated from the anisotropic conductive adhesive 400, and are welded in surface contact with the connection electrodes 110 and 310.

Accordingly, the connection electrodes 110 and 310 and the melted adhesive particle 410' have very low contact resistance. In addition, in the connection electrodes 110 and 310 and the melted adhesive particle 410', a large current can flow stably, and a physical connection is firmly achieved. In addition, the adhesive particles 410 are alloyed at the interface with electrode materials of the first electrode or the second electrode, so as to have lower contact resistance and higher interfacial adhesion.

Since the spacer particles 420 have a characteristic in that they remain in a solid state even when ultrasonic waves are applied thereto, the spacer particle 420 resist external pressure upon the application of ultrasonic waves.

The two connection electrodes 110 and 310 of the electronic components, which are connection targets, may be prevented by the spacer particle 420 from physically facing each other. Thus, the current can flow in a selective position. Further, the adhesive particle 410' may be melted and made to come in surface contact with the connection portion electrodes 110 and 310 while maintaining a constant shape.

As described above, in the anisotropic conductive adhesive 400 for ultrasonic wave adhesion according to the present invention, the thermosetting polymer resin may be cured (430'), and the adhesive particles may be melted (410') by the application of ultrasonic waves.

The polymer resin may be a resin which is cured at a temperature of 100 to 300 °C, preferably an epoxy resin, polyimide resin, acrylic resin, polyester resin, polysulfone resin, polyimide, resin, polyester resin, or a mixture thereof.

When the anisotropic conductive adhesive 400 is self-heated, it is desirable that the adhesive particles 410 be stably melted, and that the spacer particles 410 have a melting point less than $0.9 \times T_m^s$ based on the melting point ($T_m^s$, °C) of the spacer particles 420, so that the spacer particles 420 are maintained in a solid state. In this case, the melting point ($T_m^c$, °C) of the adhesive particles 410 is 120 to 300 C, and the melting point ($T_m^s$, °C) of the spacer particles 420 is 200 to 5000°C, such that the polymer resin 430 may be cured and the adhesive particles 410 may be melted by self-heating of the anisotropic conductive adhesive 400.

The average particle diameters of the adhesive particles 410 and the spacer particles 420 may range from 3μm to 100 μm, independently of each other. In this case, in terms of effective welding of the connection electrodes 110 and 310 and the adhesive particles 410, the average particle diameter of the adhesive particles 410 may be larger than that of the spacer particles 420.

The spacer particles 420 may be conductive or non-conductive particles, or a mixture of conductive particles and non-conductive particles.

When the spacer particles 420 are conductive particle, the connection electrodes 110 and 310 can be more stably conductive, and when the spacer particles 420 are non-conductive particles, the conductive selectivity of the connection electrodes 110 and 310 can be improved.

Preferably, the anisotropic conductive adhesive 400 may contain 5 to 30% by weight of the adhesive particles 410 and 1 to 20% by weight of the spacer particles 420.

In addition, it is preferable that the adhesive particles 410 be lead-free solder particles, and in detail, a Pb-based alloy, an Sn-based alloy, an Sn-Bi based alloy, an Sn-Zn based alloy, a Sn-Ag based alloy, an Sn-Ag-Au based alloy or a mixture of the alloys.

When the spacer particles 420 are non-conductive particles, it is preferable to select epoxy, polyimide, silicon, acrylic, polyester, polysulfone, aluminum oxide, silicon oxide, silicon nitride, titanium oxide, diamond, or a mixture thereof, and when the spacer particles 420 are conductive particles, it is preferable to select a polymer coated with silver, gold, copper, nickel, carbon, an intrinsically conductive polymer, or a mixture thereof.

In the anisotropic conductive adhesive 400 according to the present invention, the curing of the polymer resin and the melting of the conductive adhesive particles can be very quickly and evenly performed by the application of ultrasonic waves. In addition, since the melted adhesive particles can be easily welded by the application of pressure and ultrasonic waves, they may be free from oxidation, to thus not contain a reducing agent.

The anisotropic conductive adhesive 400 according to the present invention as described above may be a film type or a paste type, and is preferably an anisotropic conductive film.

FIG. 3 is a flow chart illustrating a method of interconnecting electronic components using an anisotropic conductive adhesive 400 according to the present invention. In the explanation of the method of interconnecting electronic components according to the present invention based on PIG. 3, since the main idea of the anisotropic conductive adhesive 400 according to the present invention is identical to that of the above-mentioned description, an explanation thereof is omitted.

The anisotropic conductive adhesive 400 is formed on a surface of a first electrode 110, which is a connection electrode of a first electronic component 100, which is a connection target.

When the anisotropic conductive adhesive 400 is a film type, the anisotropic conductive film may be attached to the surface of the first electrode 100. Is addition, when the anisotropic conductive adhesive 400 is a paste type, the surface of the first electrode 100 may be coated using screen printing, spin coating or blade coating.

Subsequently, a second electronic component 300, which is another connection target, is arranged and laminated such that the first electrode 100 may be opposite a second electrode 310, which is a connection electrode of the second electronic component 300, and then ultrasonic waves are applied to a laminate including the first electronic component 100, the anisotropic conductive adhesive 400 and the second electronic component 300.

In this case, the laminate may be located on the upper portion of a support 1000 for physical support. In addition, in order to minimize heat loss from the anisotropic conductive adhesive 400, the laminate is applied with ultrasonic vibration accompanied by pressure through an adiabatic vibration transfer mediums 2000 having low thermal conductivity.

The polymer resin 430 contained in the anisotropic conductive adhesive 400 is plastic-deformed, and heat is generated by the applied ultrasonic waves. According to the self-heating, the polymer resin 430 can be cured, the adhesives particles 410 can be melted, and the first electrode 110 and the second electrode 310 can be electrically connected to each other.

According to the present invention, the polymer resin 430 can be self-heated using the ultrasonic waves accompanied by a predetermined pressure, rather than heat transfer by an external heat source. Accordingly, since uniform temperature may be maintained, regardless of the area of the electronic component, which is a connection target, and the thickness of the anisotropic conductive adhesive, degradation of the polymer resin caused by uneven heat conduction may be prevented. In addition, since the heating occurs only in the polymer resin, thermal stress caused by differences in thermal expansion can be minimized.

In addition, the curing of the polymer resin may be significantly faster than heat transfer of the external source, and the temperature of the anisotropic conductive adhesive 400 may be controlled quickly and precisely.

In this case, the self-heating degree of the polymer resin 430 may be controlled by the pressure, frequency, amplitude, power and driving time of ultrasonic waves, or a combination thereof, and accordingly, the temperature of the anisotropic conductive adhesive 400 can be controlled quickly and precisely.

In order to cure the polymer resin 430 and melt the adhesive particles 410, the temperature of the anisotropic conductive adhesive due to the application of ultrasonic waves may range from 120 to 300 °C.

The anisotropic conductive film, which usually contains conductive Ni particles 8 $\mu$m in size, is attached between two electrodes, and heat and pressure (150 degree, 2MPa) are applied thereto. As a result of the testing of the electrical connection characteristics thereof, a contact resistance of about 9.2 mOhm may be obtained.

Meanwhile, according to the present invention, eutectic Sn/Bi solder of 20 μm and Ni of 8μm are used as the adhesive particles and spacer particles, respectively, and ultrasonic vibration is applied. As a result of the testing of the connection characteristics between two electrodes at a temperature of 225 °C, it is confirmed that a very low contact resistance of about 6.2 mOhm can be obtained. In addition, it is confirmed that the connection portion has high reliability, more than two times than that of the common anisotropic conductive film, even upon severe testing at 121°C and 2atm and a relative humidity of 100%.

According to the present invention, in the anisotropic conductive adhesive and the method of interconnecting electronic components using the anisotropic conductive adhesive, the metal particles within the anisotropic conductive adhesive may be partially melted by internal heat generated by the applied ultrasonic waves, and two electrodes, which are connection targets, may be connected by surface contact rather than point contact. Therefore, contact resistance between the two electrodes may be considerably reduced. In addition, the internal heat range (that is, the temperature of the anisotropic conductive adhesive) can be controlled very precisely and quickly to thus maintain a uniform temperature, regardless of the thickness and area of the anisotropic conductive adhesive. Further, the metal materials within the anisotropic conductive adhesive may be free from oxidation, and the internal heat of the anisotropic conductive adhesive may be used. Therefore, the thermal deformation of electronic components, which are connection targets, may be prevented, to thus achieve high reliability.

While the present invention has been described with respect to the specific embodiments, it will be apparent to those skilled in the art that various changes and modifications may be made without departing from the spirit and scope of the invention as defined in the following claims.

Therefore, all changes and modifications that fall within the metes and bounds of the claims, or equivalents of such metes and bounds, are intended to be embraced by the appended claims.

**Claims**

1. An anisotropic conductive adhesive (ACA) for ultrasonic wave adhesion, which electrically connects a first electrode, which is an electrode of a connection portion of a first electronic component, and a second electrode, which is an electrode of a connection portion of a second electronic component, the anisotropic conductive adhesives comprising:

   an insulating polymer resin;
   conductive adhesive particles, which melt with heat generated from ultrasonic waves applied to the anisotropic conductive adhesive; and
   spacer particles, which have a melting point higher than a melting point of the adhesive particles,
   wherein the adhesive particles are melted and made to come in surface contact with at least one electrode selected from the first electrode and the second electrode, and the first electrode and the second electrode are electrically connected with a constant gap maintained between the first electrode and the second electrode by the spacer particles.

2. The anisotropic conductive adhesive according to claim 1, wherein a plastic deformation of the polymer resin is caused by the applied ultrasonic waves, and the adhesive particles are melted by self-heating of polymer resin according to the plastic deformation.

3. The anisotropic conductive adhesive according to claim 2, wherein the spacer particles are conductive or conducive particles that remain in a solid state when the ultrasonic waves are applied, the gap between the first electrode and the second electrode is maintained against the applied pressure when the first electronic component and the second electronic component are connected such that the melted adhesive particles have uniform apparent adhesion, and the adhesive particles are alloyed with electrode materials of the first electrode or the second electrode by the melting of the adhesive particles.

4. The anisotropic conductive adhesive according to claim 2, wherein an average particle diameter of the adhesive particles is larger than an average particle diameter of the spacer particles, and the average particle diameters of the adhesive particles and the spacer particles are 3μm to 100 μm, independently of each other.

5. The anisotropic conductive adhesive according to claim 2, wherein the insulating polymer resin is a thermosetting polymer resin or a thermoplastic polymer resin, and the thermosetting polymer resin is cured, or the thermoplastic polymer resin is melted and the adhesive particles are melted by the applied ultrasonic waves.

6. The anisotropic conductive adhesive according to claim 2, wherein the anisotropic conductive adhesive contains 5 to 30% by weight of the adhesive particles and 1 to 50% by weight of the spacer particles.

7. The anisotropic conductive adhesive according to claim 6, wherein the adhesive particles are a Pb-based alloy, an Sn-based alloy, an Sn-Bi based alloy, an Sn-Zn based alloy, an Sn-Ag based alloy, and an Sn-Ag-Au based alloy, or a mixture of the alloys, as a solder alloy.

8. The anisotropic conductive adhesive according to claim 7, wherein the spacer particles are at least one non-conductive particle selected from polymer particles containing epoxy, polyimide, silicon, acrylic, polyester, polysulfone, and polystyrene, and ceramic particles containing aluminum oxide, silicon oxide, silicon nitride, titanium oxide and diamond, or at least one conductive particle selected from a polymer coated with silver, gold, copper, nickel, carbon and an intrinsically conductive polymer.

9. A method of interconnecting electronic components using an anisotropic conductive adhesive for ultrasonic wave adhesion, comprising:

    (a) forming the anisotropic conductive adhesive of any one of claims 1 to 8 on the upper portion of an electrode of a connection portion of a first electronic component, on which electrodes of the connection portion are formed for electrical interconnection of homogeneous or heterogeneous electronic components; and
    (b) interconnecting the electrodes of the connection portion of the first electronic component and the electrodes of the connection portion of the second electronic components, comprising:

        forming a laminate including the first electronic component, the anisotropic conductive adhesive and the second electronic component by arranging and stacking the electrode of the connection portion of the second electronic component on the upper side of the electrode of the connection portion of the first electronic component, wherein the anisotropic conductive adhesive is between the electrodes;
        causing plastic deformation of an insulating thermosetting or thermoplastic polymer resin contained in the anisotropic conductive adhesive by applying ultrasonic vibration and pressure to the laminate;
        curing or melting the polymer resin contained in the anisotropic conductive adhesive by self-heating of the polymer resin according to the plastic deformation; and
        melting adhesive particles contained in the anisotropic conductive adhesive.

10. The interconnecting method according to claim 9, wherein the temperature of the anisotropic conductive adhesive by self-heating of the polymer resin is controlled by pressure, frequency, amplitude, power and driving time of an ultrasonic wave, or a combination of thereof.

# FIG. 1A

## (Prior Art)

FIG. 1B

(Prior Art)

110

210

310

# FIG. 2

ULTRA SONIC VIBRATION

ULTRA SONIC VIBRATION

## FIG. 3

ULTRA SONIC VIBRATION WITH
PRESSURE

## INTERNATIONAL SEARCH REPORT

| | International application No. |
|---|---|
| | **PCT/KR2010/000477** |

**A. CLASSIFICATION OF SUBJECT MATTER**

***C09J 9/02(2006.01)i, C09J 5/02(2006.01)i***

According to International Patent Classification (IPC) or to both national classification and IPC

**B. FIELDS SEARCHED**

Minimum documentation searched (classification system followed by classification symbols)

C09J 9/02; C09J 163/00; C09J 201/00; H01F 1/14; H01L 21/58; H01L 23/48; H01L 23/50; H01R 4/58; H01R 9/09

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)

eKOMPASS (KIPO internal) & Keywords: anisotropy, conductivity, adhesive, ultrasonic wave

**C. DOCUMENTS CONSIDERED TO BE RELEVANT**

| Category* | Citation of document, with indication, where appropriate, of the relevant passages | Relevant to claim No. |
|---|---|---|
| A | EP 0344719 A2 (CANON KABUSHIKI KAISHA) 06 December 1989<br>See column 4 line 21 - column 5 line 13, examples 10, 15 | 1-10 |
| A | KR 10-0389743 B1 (LOCTITE (IRELAND) LIMITED) 04 October 2003<br>See figures 1-3, claims 1-13 | 1-10 |
| A | KR 10-0305750 B1 (KOREA ADVANCED INSTITUTE OF SCIENCE AND TECHNOLOGY) 24 September 2001<br>See figures 3-4, claims 1-5 | 1-10 |
| A | US 5225966 A1 (BASAVANHALLY; NAGESH R. et al.) 06 July 1993<br>See figures 1-3, column 2 line 64 - column 4 line 63 | 1-10 |
| A | JP 2007-254527 A (TORAY IND INC) 04 October 2007<br>See sections 6-31 | 1-10 |

☐ Further documents are listed in the continuation of Box C.  ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 11 AUGUST 2010 (11.08.2010) | **13 AUGUST 2010 (13.08.2010)** |

| Name and mailing address of the ISA/KR<br>Korean Intellectual Property Office<br>Government Complex-Daejeon, 139 Seonsa-ro, Daejeon 302-701, Republic of Korea<br>Facsimile No. 82-42-472-7140 | Authorized officer<br><br>Telephone No. |
|---|---|

Form PCT/ISA/210 (second sheet) (July 2009)

INTERNATIONAL SEARCH REPORT
Information on patent family members

International application No.

**PCT/KR2010/000477**

| Patent document cited in search report | Publication date | Patent family member | Publication date |
|---|---|---|---|
| EP 0344719 A2 | 06.12.1989 | DE 68925598 D1 | 21.03.1996 |
| | | DE 68925598 T2 | 17.10.1996 |
| | | EP 0344719 A3 | 16.08.1990 |
| | | EP 0344719 B1 | 07.02.1996 |
| | | JP 01-302830 A | 06.12.1989 |
| | | JP 01-302831 A | 06.12.1989 |
| | | US 5197892 A1 | 30.03.1993 |
| KR 10-0389743 B1 | 04.10.2003 | EP 0692137 A1 | 17.01.1996 |
| | | EP 0692137 B1 | 10.04.2002 |
| | | JP 03-057577 B2 | 21.04.2000 |
| | | JP 08-508610 A | 10.09.1996 |
| | | US 5769996 A1 | 23.06.1998 |
| | | US 6110399 A1 | 29.08.2000 |
| | | WO 95-20820 A1 | 03.08.1995 |
| KR 10-0305750 B1 | 24.09.2001 | JP 03-675285 B2 | 27.07.2005 |
| | | JP 2000-309768 A | 07.11.2000 |
| | | US 6238597 B1 | 29.05.2001 |
| US 5225966 A1 | 06.07.1993 | JP 02-509053 B2 | 16.04.1996 |
| | | JP 07-058148 A | 03.03.1995 |
| JP 2007-254527 A | 04.10.2007 | None | |

Form PCT/ISA/210 (patent family annex) (July 2009)